# FASCICULE DE BREVET EUROPEEN

(11) **EP 1 134 695 B1**
(45) Date de publication et mention de la délivrance du brevet: **24.03.2004**
(21) Numéro de dépôt: 01400243.0
(22) Date de dépôt: 31.01.2001
(51) Int. Cl.: G06K 19/077

(54) **Carte à microcircuit comportant une plaquette détachable en partie prédécoupée dans un corps de carte**
ChipKarte mit einer aus einem bereichsweise vorgeschnittenem Träger abtrennnbaren Platte
Microchip card comprising a separable board that is partially precut in a card substrate

(30) Priorité: 18.02.2000 FR 0002032
(43) Date de publication de la demande: 19.09.2001
(73) Titulaire: OBERTHUR CARD SYSTEMS SA, 75017 Paris (FR)
(72) Inventeur: Enouf, Guy, 14190 Saint Sylvain (FR)
(74) Mandataire: Santarelli

(56) Documents cités:
- DE-C- 19 726 203
- US-A- 5 936 227

## Description

L'invention se rapporte à une carte à microcircuit à plages de contact, du type dans laquelle le microcircuit et les plages de contact font partie d'une plaquette détachable en partie prédécoupée dans un corps de carte. Elle concerne plus particulièrement un perfectionnement relatif à la structure des moyens d'attache entre la plaquette détachable et le corps de carte permettant de concilier divers impératifs a priori contradictoires, à savoir, principalement, un bon comportement de la carte vis-à-vis des différents tests de flexion normalisés et une facilité de détachement de la plaquette lorsqu'il est nécessaire de la séparer du corps de carte.

On connaît un type de carte à microcircuit à plages de contact, dans lequel le microcircuit et les plages de contact font partie d'une plaquette détachable en partie prédécoupée dans un corps de carte par la présence de fentes délimitant sensiblement son périmètre. Selon les cas, la carte peut être utilisée telle quelle dans un appareil destiné à la recevoir ou bien elle peut être détachée du corps de carte pour être placée dans un appareil miniaturisé. Ce type de carte est particulièrement utilisé dans les téléphones mobiles. Son format est conforme aux normes internationales GSM 11.11 et ISO 7816.

Par exemple, le document FR 2 773 900 décrit une carte de ce genre comportant des languettes de liaison cassables s'étendant entre le corps de carte et la plaquette détachable. Mis à part les parties cassables, la plaquette détachable apparaît prédécoupée dans le corps de carte par la présence de fentes délimitant sensiblement son périmètre. Cependant, toutes ces parties cassables sont pourvues de rainures ou entailles permettant d'amorcer la rupture au moment de la séparation de la plaquette. Ces entailles sont réalisées par tranchage. Or, le tranchage est une opération délicate à réaliser à l'échelon industriel, la profondeur des entailles pouvant varier en fonction du réglage des outils de coupe ou au fur et à mesure de l'usure de ceux-ci. Il est donc difficile de concilier deux impératifs essentiels, à savoir un détachement facile d'une part, et une résistance suffisante aux efforts de flexion/torsion d'autre part. Une carte est appelée à subir de tels efforts lors des manipulations au passage dans les équipements de personnalisation ou ensachage, avant détachement éventuel de la plaquette. On rappelle que des tests de flexion/torsion sont définis par les normes ISO 78161-2 et ISO 10373.

L'invention a pour but de supprimer au moins une partie et de préférence toutes les opérations de tranchage.

Dans ce but, l'invention concerne une carte à microcircuit à plages de contact, dans laquelle ledit microcircuit et lesdites plages de contact font partie d'une plaquette détachable en partie prédécoupée dans un corps de carte par la présence de fentes délimitant sensiblement son périmètre, des languettes de liaison cassables s'étendant entre ledit corps de carte et ladite plaquette détachable, caractérisée en ce qu'une telle languette cassable est dépourvue d'entaille, son épaisseur étant constante en tout point, et présente une largeur décroissante du corps de carte jusqu'à ladite plaquette détachable, ayant approximativement la forme d'un triangle, un côté de ce triangle se confondant sensiblement avec ledit corps de carte et le sommet opposé à ce côté, se confondant sensiblement avec le bord de ladite plaquette.

Autrement dit, une telle languette ne comporte pas d'entailles résultant d'un tranchage, son épaisseur étant constante en tout point et égale à celle de la carte. Néanmoins, on a trouvé qu'en donnant à la languette cette forme particulière se traduisant par un rattachement quasi ponctuel au voisinage du bord de la plaquette détachable, cette dernière pouvait être séparée facilement du corps de carte avec une variation très faible de l'effort de détachement d'une carte à l'autre.

En outre, la souplesse des attaches ainsi réalisées permet d'améliorer encore les résultats des tests de flexion.

L'invention propose ainsi une géométrie plus simple et moins coûteuse que celle proposée par le document US-5 531 145, à savoir une forme trapézoïdale dont la petite base est matérialisée par un alignement de perforations.

De telles languettes sont de préférence prévues à certains angles de ladite plaquette. Dans le cas où la plaquette détachable est approximativement rectangulaire à un pan coupé, ce qui correspond à une forme normalisée, une telle languette cassable peut être rattachée audit pan coupé.

Un autre problème résulte du fait que, pour certaines utilisations, la plaquette ne doit pas être détachée du corps de carte. La carte, c'est-à-dire le corps de carte et la plaquette, peut être insérée dans un appareil prévu à cet effet. La carte a un contour approximativement rectangulaire et le sens d'insertion est parallèle aux grands côtés de celle-ci.

Dans la suite du texte, on appelle "bord d'insertion" de la carte, le premier bord (perpendiculaire à la direction d'insertion) à être introduit dans une machine telle qu'un lecteur de carte. La plaquette, quant à elle, a une forme approximativement rectangulaire comme indiqué ci-dessus et comporte aussi un bord parallèle audit bord d'insertion, c'est-à-dire perpendiculaire à la direction d'insertion.

Si le lecteur comporte des contacts frottants, ceux-ci ne doivent pas rencontrer de fentes traversantes telles que celles qui délimitent la plus grande partie du périmètre de la plaquette détachable. C'est pourquoi, une partie notable du bord de cette plaquette, parallèle audit bord d'insertion et proche de celui-ci peut être délimitée par au moins une incision de prédécoupage non traversante, par exemple à profil en V, cette partie incisée se situant notamment entre les plages de contact et ledit bord d'insertion. La technique classique de tranchage peut être utilisée pour réaliser cette partie du périmètre de la plaquette. De préférence, on prévoit une double incision de prédécoupage, de chaque côté de la carte. Cependant, conformément à une variante préférée, on peut remplacer cette incision ou cette double incision par plusieurs languettes précitées, disposées côte à côte et séparées par des fentes traversantes, dès lors que ces languettes s'étendent dans le prolongement des plages de contact suivant la direction d'insertion de la carte.

L'invention sera mieux comprise et d'autres avantages de celle-ci apparaîtront plus clairement à la lumière de la description qui va suivre de plusieurs cartes à microcircuit conformes à son principe, donnée uniquement à titre d'exemple et faite en référence aux dessins annexés dans lesquels :
- la figure 1 est une vue en plan d'une carte à microcircuit conforme à l'invention ;
- la figure 2 est une vue de détail à plus grande échelle de l'encadré II de la figure 1, montrant plus particulièrement la plaquette détachable ;
- la figure 3 est une vue de détail à plus grande échelle de l'encadré III de la figure 2 ;
- la figure 4 est une vue de détail à plus grande échelle de l'encadré IV de la figure 2 ;
- la figure 5 est une coupe partielle V-V de la figure 2 ; et
- la figure 6 est une vue analogue à la figure 2, illustrant une variante.

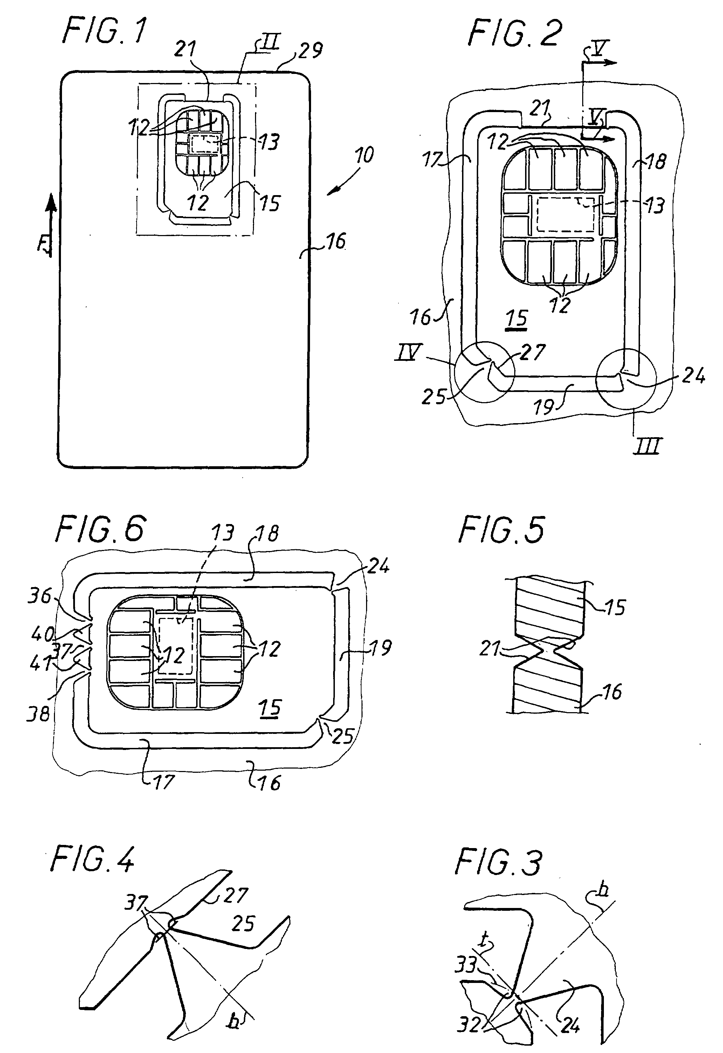

En considérant plus particulièrement les figures 1 à 5, on a représenté une carte à microcircuit 10 du type à raccordement par plages de contact 12 et dans laquelle le microcircuit 13 et les plages de contact 12 sont portés par une plaquette détachable 15 en partie prédécoupée dans un corps de carte 16. Le contour de la plaquette détachable apparaît grâce à la présence de fentes 17, 18, 19, dans le corps de carte, délimitant sensiblement le périmètre de ladite plaquette.

Dans le mode de réalisation décrit, la plaquette 15 se trouve rattachée au corps de carte par une double incision de prédécoupage 21, non traversante, ici à profil en V, et des languettes de liaison cassables 24, 25 s'étendant entre le corps de carte et la plaquette détachable.

Comme mentionné précédemment, une telle carte à microcircuit peut être utilisée telle quelle dans certains appareils, c'est-à-dire que la plaquette détachable 15 reste rattachée au corps de carte 16, ou bien ladite plaquette détachable est séparée du corps de carte pour être installée dans un autre type d'appareil, par exemple un téléphone portable.

La plaquette détachable 15 a pratiquement la forme d'un rectangle présentant un pan coupé 27. Par ailleurs, classiquement, le corps de carte a lui aussi approximativement la forme d'un rectangle et les bords de la plaquette sont parallèles aux bords du corps de carte, respectivement. On appelle ici bord d'insertion 29 du corps de carte, le bord, perpendiculaire à la direction d'insertion de la carte dans un appareil (flèche F sur la figure 1) et qui est introduit en premier dans un tel appareil lorsqu'on désire connecter la carte audit appareil.

Il est à noter que l'incision de prédécoupage 21 non traversante, réalisée par tranchage classique, est parallèle au bord d'insertion 29 du corps de carte et se situe, notamment, entre les plages de contact 12 et ledit bord d'insertion 29. Ladite incision s'étend ici entre deux fentes 17, 18 délimitant le périmètre de la plaquette.

Dans l'exemple représenté, la plaquette 15 est également rattachée au corps de carte par deux languettes de liaison cassables. La languette 24 se rattache à un "angle" de la plaquette détachable éloigné de l'incision 21 et l'autre languette 25 se rattache sensiblement au milieu du pan coupé 27.

Selon une caractéristique importante de l'invention, une telle languette cassable 24, 25 est d'épaisseur sensiblement constante, (c'est-à-dire qu'elle ne comporte pas de partie incisée par tranchage) et présente une largeur décroissante, du corps de carte 16 jusqu'à la plaquette détachable 15.

Plus précisément, une telle languette a approximativement, ici, la forme d'un triangle. Un côté de ce triangle se confond avec le corps de carte et le sommet opposé à ce côté se confond avec le bord de la plaquette.

Comme on peut le voir sur les figures 3 et 4, la bissectrice b de l'angle du sommet rattaché à ladite plaquette est sensiblement perpendiculaire à la tangente au bord de la plaquette qui passe par le point de jonction entre celle-ci et ladite languette. Pour la languette de la figure 3, la tangente, t, à prendre en considération est celle du milieu du bord arrondi 33 de la plaquette à un angle de celle-ci représenté en trait fantôme. Pour la languette de la figure 4, la tangente se confond avec le bord du pan coupé 27.

Il est à noter que dans ces deux exemples, la zone de raccordement entre la languette et la plaquette est conformée de sorte que la ligne de rupture qui doit intervenir en cas de détachement de la plaquette n'excède pas le bord théorique (normalisé) de la plaquette.

Sur la figure 3, on voit, par exemple, qu'on a réalisé deux petites incisions de part et d'autre du point de jonction de la languette, qui s'engagent au-delà du périmètre théorique de celle-ci et font pratiquement disparaître le bord arrondi 33.

Sur la figure 4, on distingue également deux encoches 37 s'engageant à l'intérieur du périmètre de la languette, en l'occurrence ici, le bord du pan coupé 27.

Le même principe est appliqué à la jonction entre les extrémités de l'incision de prédécoupage 21 et les extrémités correspondantes des fentes 17 et 18.

L'angle au sommet rattaché à la plaquette peut être compris entre, approximativement 50° et 90°.

Dans l'exemple, l'angle du sommet rattaché à la plaquette est voisin de 60°.

Dans l'exemple de la figure 6, les éléments de structure analogue portent les mêmes références numériques. Ce mode de réalisation est remarquable en ce que l'incision de prédécoupage réalisé par tranchage a été supprimée au profit de plusieurs languettes 36, 37, 38 conformes à l'invention, disposées pour que des contacts frottants d'un appareil devant être mis en contact électrique avec les plages de raccordement 12 puissent glisser à la surface du corps de carte sans rencontrer de fente. Dans ce cas, le bord de la plaquette parallèle au bord d'insertion 29 et le plus proche de celui-ci est rattaché au corps de carte par trois languettes de ce type, s'étendant dans le prolongement des plages de contact, suivant la direction d'insertion de la carte. Les trois languettes 36, 37, 38 sont séparées par de courtes fentes 40, 41. Par conséquent, si la plaquette 15 n'est pas détachée du corps de carte 16, les éléments de contact frottants d'un appareil extérieur, auquel la carte est raccordée, ne risquent pas d'être déformés ou endommagés en s'engageant dans des fentes délimitant la plaquette.

## Revendications

1. Carte à microcircuit à plages de contact, dans laquelle ledit microcircuit et lesdites plages de contact font partie d'une plaquette détachable (15) en partie prédécoupée dans un corps de carte (16) par la présence de fentes délimitant sensiblement son périmètre, des languettes de liaison cassables s'étendant entre ledit corps de carte et ladite plaquette détachable, **caractérisée en ce qu'**une telle languette cassable (24, 25) est dépourvue d'entaille, son épaisseur étant constante en tout point, et présente une largeur décroissante du corps de carte jusqu'à ladite plaquette détachable, ayant approximativement la forme d'un triangle, un côté de ce triangle se confondant avec ledit corps de carte et le sommet opposé à ce côté se confondant avec le bord de ladite plaquette.

2. Carte à microcircuit selon la revendication 1, dans laquelle ladite plaquette détachable (15) est approximativement rectangulaire, **caractérisée en ce qu'**une telle languette cassable (24) est rattachée à un angle de ladite plaquette.

3. Carte à microcircuit selon la revendication 1 ou la revendication 2, dans laquelle ladite plaquette détachable est approximativement rectangulaire à pan coupé (27), **caractérisée en ce qu'**une telle languette cassable (25) est rattachée audit pan coupé.

4. Carte à microcircuit selon l'une quelconque des revendications 1 à 3, **caractérisée en ce que** la bissectrice (b) de l'angle du sommet rattaché à ladite plaquette, est sensiblement perpendiculaire à la tangente au bord de ladite plaquette passant par le point de jonction entre celle-ci et ladite languette.

5. Carte à microcircuit selon la revendication 4, **caractérisée en ce que** l'angle dudit sommet rattaché à ladite plaquette est compris entre 50° et 90°, environ.

6. Carte à microcircuit selon la revendication 5, **caractérisée en ce que** l'angle dudit sommet rattaché à ladite plaquette est voisin de 60°.

7. Carte à microcircuit selon l'une quelconque des revendications précédentes, **caractérisée en ce que** la zone de raccordement entre ladite languette et ladite plaquette est conformée de sorte que la ligne de rupture n'excède pas le bord prévu de ladite plaquette après détachement de celle-ci.

8. Carte à microcircuit selon la revendication 7, **caractérisée en ce que** cette zone de raccordement comporte deux encoches (37) ou incisions.

9. Carte à microcircuit selon l'une quelconque des revendications précédentes, **caractérisée en ce que** le bord de la plaquette parallèle à un bord d'insertion du corps de carte et le plus proche de celui-ci est rattaché au corps de carte par des languettes précitées (36, 37, 38) s'étendant dans le prolongement des plages de contact suivant la direction d'insertion de la carte.

10. Carte à microcircuit selon l'une quelconque des revendications 1 à 8, **caractérisée en ce qu'**une partie du bord de la plaquette, parallèle à un bord d'insertion du corps de carte et le plus proche de celui-ci est défini par au moins une incision de prédécoupage (21) non traversante, par exemple à profil en V, cette partie incisée se situant notamment entre les plages de contact et ledit bord d'insertion.

## Claims

1. Microcircuit card with contact pads, in which said microcircuit and said contact pads form part of a detachable plate (15) partly precut from a card body (16) by the presence of slots substantially delimiting its perimeter, frangible linking tabs extending between said card body and said detachable plate, **characterized in that** such a frangible tab (24, 25) has no indent, its thickness being constant at all points, and has a width decreasing from the card body to said detachable plate, having approximately the form of a triangle, one side of the triangle coinciding with said card body and the vertex opposite that side coinciding with the edge of said plate.

2. A microcircuit card according to claim 1, in which said detachable plate (15) is approximately rectangular, **characterized in that** such a frangible tab (24) is attached to a corner of said plate.

3. A microcircuit card according to claim 1 or claim 2, in which said detachable plate is approximately rectangular with a cut-off corner (27), **characterized in that** such a frangible tab (25) is attached to said cut-off corner.

4. A microcircuit card according to any one of claims 1 to 3, **characterized in that** the bisecting line (b) of the angle of the vertex attached to said plate, is substantially perpendicular to the tangent to the edge of said plate passing through the junction point between it and said tab.

5. Microcircuit card according to claim 4, **characterized in that** the angle of said apex attached to said plate is between 50° and 90°, approximately.

6. Microcircuit card according to claim 5, **characterized in that** the angle of said apex attached to said plate is in the neighborhood of 60°.

7. A microcircuit card according to any one of the preceding claims, **characterized in that** the zone of attachment between said tab and said plate is formed such that the fracture line does not extend over the edge provided for said plate after its detachment.

8. A microcircuit card according to claim 7, **characterized in that** said attachment zone comprises two notches (37) or incisions.

9. A microcircuit card according to any one of the preceding claims, **characterized in that** the edge of the plate parallel to an insertion edge of the card body and the closest to it is attached to the card body by aforementioned tabs (36, 37, 38) extending in line with the contact pads in the direction of insertion of the card.

10. A microcircuit card according to any one of claims 1 to 8, **characterized in that** a portion of the edge of the plate, parallel to an insertion edge of the card body and the closest to it is defined by at least one precutting incision (21) not passing all the way through, for example of V-section, this incised portion being situated in particular between the contact pads and the insertion edge.

## Patentansprüche

1. Chipkarte bzw. Mikroschaltungskarte mit Kontaktbereichen, in welcher der Mikrochip und die Kontaktbereiche Teile einer lösbaren Platte bzw. Plättchen bzw. Scheibe (15) ausbilden, die teilweise in einem Kartenkörper (16) durch die Anwesenheit von Schlitzen vorgeschnitten ist, welche im wesentlichen ihren Umfang begrenzen, wobei sich zerbrechbare Verbindungszungen zwischen dem Kartenkörper und der lösbaren Platte erstrecken, **dadurch gekennzeichnet, daß** eine derartige zerbrechbare Zunge (24, 25) frei von einem Einschnitt bzw. Einkerbung ist, wobei ihre Dicke in jedem Punkt konstant ist, und eine abfallende bzw. abnehmende Breite des Körpers der Karte bis zu der lösbaren Platte aufweist, die annähernd die Form eines Dreiecks aufweist, wobei eine Seite des Dreiecks mit dem Kartenkörper zusammenfällt bzw. überlappt und die dieser Seite gegenüberliegende Spitze mit dem Rand der Platte zusammenfällt bzw. überlappt.

2. Chipkarte nach Anspruch 1, in welcher die lösbare Platte (15) annähernd rechteckig ist, **dadurch gekennzeichnet, daß** die zerbrechbare Zunge (24) mit einem Winkel dieser Platte verbunden ist.

3. Chipkarte nach Anspruch 1 oder Anspruch 2, in welcher die lösbare Platte annähernd rechteckig mit einer schrägen Kante bzw. Abschrägung (27) ist, **dadurch gekennzeichnet, daß** die zerbrechbare Zunge (25) mit der schrägen Kante verbunden ist.

4. Chipkarte nach einem der Ansprüche 1 bis 3, **dadurch gekennzeichnet, daß** die Halbierende (b) des Winkels der Spitze, die mit der Platte verbunden ist, im wesentlichen senkrecht auf die Tangente an den Rand der Platte ist, die durch den Verbindungspunkt zwischen dieser und der Zunge hindurchgeht.

5. Chipkarte nach Anspruch 4, **dadurch gekennzeichnet, daß** der Winkel der Spitze, die mit der Platte verbunden ist, etwa 50° bis 90° beträgt.

6. Chipkarte nach Anspruch 5, **dadurch gekennzeichnet, daß** der Winkel der Spitze, die mit der Platte verbunden ist, etwa 60° beträgt.

7. Chipkarte nach einem der vorhergehenden Ansprüche, **dadurch gekennzeichnet, daß** die Anschluß- bzw. Verbindungszone zwischen der Zunge und der Platte derart übereinstimmt, daß sich die Bruchlinie nicht über den vorgesehenen Rand der Platte nach einem Lösen derselben erstreckt.

8. Chipkarte nach Anspruch 7, **dadurch gekennzeichnet, daß** die Verbindungszone zwei Kerbschnitte bzw. Kerben (37) oder Einschnitte umfaßt.

9. Chipkarte nach einem der vorhergehenden Ansprüche, **dadurch gekennzeichnet, daß** der Rand der Platte parallel zu einem Einsetzrand des Körpers der Karte und am nächsten zu jenem an dem Kartenkörper durch die vorgenannten Zungen (36, 37, 38) festgelegt ist, welche sich in der Verlängerung der Kontaktbereiche entsprechend der Einsetzrichtung der Karte erstrecken.

10. Chipkarte nach einem der Ansprüche 1 bis 8, **dadurch gekennzeichnet, daß** ein Teil des Rands der Platte parallel zu einem Einsetzrand des Körpers der Karte und am nächsten zu jenem durch wenigstens einen nicht durchtretenden Vor-Einschnitt (21), beispielsweise in einem V-Profil definiert ist, wobei der eingeschnittene Bereich insbesondere zwischen den Kontaktbereichen und dem Einsetzrand angeordnet ist.
